# EUROPÄISCHE PATENTSCHRIFT

(11) **EP 0 365 706 B1**
(45) Veröffentlichungstag und Bekanntmachung des Hinweises auf die Patenterteilung: **03.02.1993**
(21) Anmeldenummer: 88117942.8
(22) Anmeldetag: 27.10.1988
(51) Int. Cl.: H03K 17/06

(54) **Leistungsendstufe mit einer Last**
Power output stage with a load
Etage de sortie de puissance avec une charge

(43) Veröffentlichungstag der Anmeldung: 02.05.1990
(73) Patentinhaber: SIEMENS AKTIENGESELLSCHAFT, 80333 München (DE)
(72) Erfinder: Kumpfmüller, Hans-Georg, Dipl.-Ing., D-8405 Donaustauf (DE); Schäfer, Joachim, Dipl.-Ing., D-8440 Straubing-Kagers (DE)

(56) Entgegenhaltungen:
- EP-A- 0 229 482
- EP-A- 0 236 967
- US-A- 3 866 060
- NEW ELECTRONICS, Band 18, Nr. 13, 25. Juni 1985, Seite 25, London, GB; G. PECKHAM: "CMOS driver for high threshold MOSFETS"

## Beschreibung

Die Erfindung bezieht sich auf eine Leistungsendstufe mit einer Last, die über die Source-Drain-Strecke eines Feldeffekt-Transistors (FET) an eine Gleichspannungsquelle angeschlossen ist, nach dem Oberbegriff des Patentanspruchs (EP-A 02 36 967).

Soll der Feldeffekt-Transistor durchgeschaltet werden, so muß das Potential an seinem Gateanschluß um einige Volt höher liegen als an seinem Drainanschluß.

Die bekannte Schaltungsanordnung weist einen FET auf, dessen Source-Drain-Strecke in Reihe mit einer zu schaltenden Last an einer Spannungsquelle (Arbeitsstromkreis) liegt. Der eine Anschluß eines Kondensators ist über eine Diode an eine Spannungsquelle (Ladestromkreis) und über eine weitere Diode an den Gateanschluß des FET (Steuerstromkreis) angeschlossen, wobei zwischen den beiden Dioden und der Spannungsquelle jeweils ein Schalter angeordnet ist. Dem anderen Anschluß des Kondensators wird eine getaktete Gleichspannung zugeführt, wenn der FET durchschalten soll. Gleichzeitig muß der eine Schalter geschlossen und der andere geöffnet sein.

Der Erfindung liegt die Aufgabe zugrunde, eine Schaltungsanordnung der genannten Art zu vereinfachen.

Diese Aufgabe wird durch die im Patentanspruch genannten Merkmale gelöst.

Der besondere Vorteil der Erfindung gegenüber der bekannten Schaltungsanordnung liegt darin, daß anstelle von zwei Schaltern und drei unterschiedlichen Steuerspannungen nur noch ein Schalter und eine Steuerspannung erforderlich sind.

Die Erfindung wird am Beispiel einer Leistungsendstufe mit induktiver Last anhand der Figuren näher erläutert. Es zeigen
- Figur 1: ein Schaltbild der erfindungsgemäßen Schaltungsanordnung und
- Figur 2: den zeitlichen Verlauf
a) der Steuerspannung U(BT1),
b) der Spannung U(B) am Verbindungspunkt B,
c) der Spannung U(G) am Gateanschluß G und
d) von Spannung U(L) und Strom i(L) an der Last L.

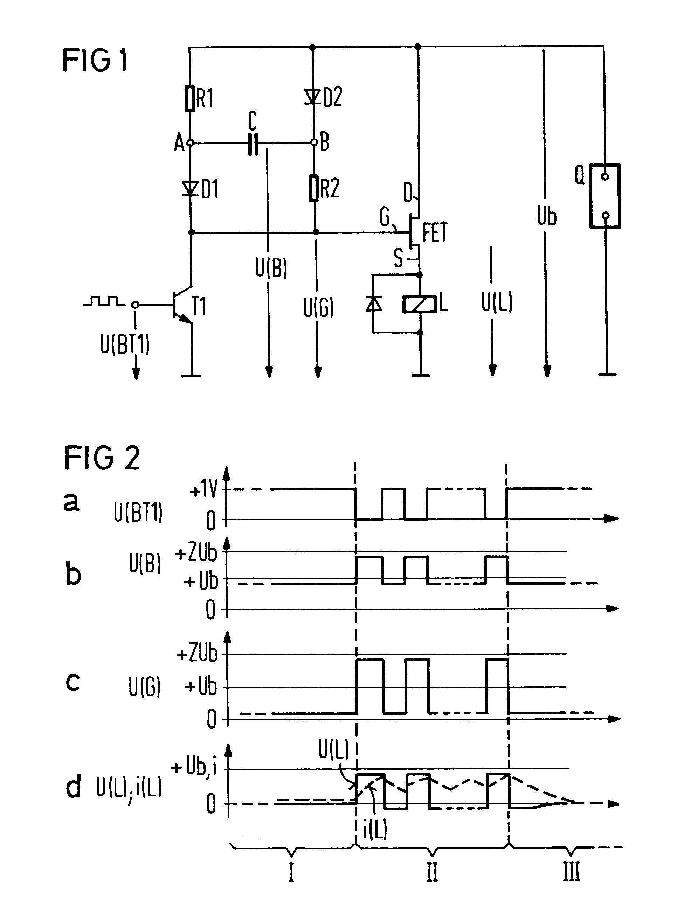

Die Last L in Figur 1 ist als Erregerwicklung eines Relais mit parallel geschalteter Löschdiode dargestellt. Diese Last L ist über die Source-DrainStrecke eines Feldeffekt-Transistors an eine Spannungsquelle Q angeschlossen (Arbeitsstromkreis). Der FET ist beispielsweise ein Power-MOS-Transistor. Der Gateanschluß G des FET ist mit dem Kollektor eines Steuertransistors T1 verbunden, dessen Emitter an Masse - dem negativen Pol der Spannungsquelle -liegt und an dessen Basis eine Steuerspannung U(BT1) anlegbar ist.

Zwischen dem positiven Pol der Spannungsquelle und dem Drainanschluß D einerseits und dem Gateanschluß G andererseits ist eine Schaltung aus fünf Bauelementen eingefügt. Zwischen der Spannungsquelle Q und einem ersten Verbindungspunkt A liegt ein erster Widerstand R1, zwischen dem ersten Verbindungspunkt A und dem Gateanschluß G liegt eine erste Diode D1 in Durchlaßrichtung zum Gateanschluß G. Von der Spannungsquelle Q in Durchlaßrichtung zu einem zweiten Verbindungspunkt B liegt eine zweite Diode D2 und zwischen dem zweiten Verbindungspunkt B und dem Gateanschluß G liegt ein zweiter Widerstand R2. Zwischen den beiden Verbindungspunkten A und B liegt ein Kondensator C.

Im Ruhezustand ist die Schaltungsanordnung an die Spannungsquelle Q angeschlossen. An der Basis des Steuertransistors T1 liegt eine den Transistor duchsteuernde konstante Gleichspannung U(BT1) = 1 Volt.

Der Gateanschluß G und der Verbindungspunkt A liegen nahezu auf Massepotential, der Verbindungspunkt B hingegen nahezu auf dem Potential Ub der Spannungsquelle Q: der Kondensator C ist aufgeladen.

Da der Gateanschluß G nahezu auf Massepotential liegt, ist der FET gesperrt; Spannung U(L) und Strom i(L) an der Last sind Null.

Soll nun die Last L mit der Spannungsquelle Q verbunden werden (Bereich II in Figur 2), so muß als Steuersignal U(BT1) eine getaktete Gleichspannung an die Basis des Steuertransistors T1 angelegt werden, deren Amplitude periodisch zwischen den Werten 1 V und 0 V wechselt (Figur 2a, Bereich II).

Mit der Impulspause des Steuersignals U(BT1) geht der Steuertransistor T1 in den nicht leitenden Zustand und die Spannung am Verbindungspunkt A springt auf den Wert +Ub. Um den gleichen Betrag springt die Spannung U(B) am Verbindungspunkt B auf nahezu +2Ub (Figur 2b). Dieser Spannungswert wird auf den Gateanschluß G übertragen (Figur 2c) und der FET geht in den leitenden Zustand über. Der Steuerstromkreis besteht aus der Spannungsquelle, den beiden Widerständen R1, R2, dem Kondensator C, der Gate-Source-Strecke des FET und der Last L. An der Last L liegt die Spannung U(L), welche nur um den geringen Spannungsabfall am FET geringer ist als die Spannung +Ub der Spannungsquelle (Figur 2d). Ein rasch anwachsender Laststrom i(L) ist die Folge (gestrichelte Linie in Figur 2d).

Mit dem nächsten Impuls der Steuerspannung U(BT1) wird der Steuertransistor T1 wieder leitend, der Gateanschluß G wird mit Masse verbunden und der FET sperrt. Die Spannung U(L) wird nahezu Null und der Laststrom i(L) wird kleiner. Das Potential am Verbindungspunkt A fällt auf nahezu Massepotential und das Potential am Verbindungspunkt B wird um denselben Betrag verringert. Es fließt wieder ein Strom durch den Kondensator C, wodurch dieser nachgeladen wird. Mit der nächsten Impulspause des Steuersignals U(BT1) wiederholen sich die Vorgänge, wie bereits beschrieben.

Diese Vorgänge (Figur 2a bis d, Bereich II) wiederholen sich, solange die getaktete Gleichspannung als Steuersignal U(BT1) am Steuertransistor T1 anliegt. Nach Umschalten des Steuersignals U(BT1) auf die konstante Gleichspannung U(BT1) = 1 V kehrt die Schaltungsanordnung in den Ruhezustand zurück (Figur 2a bis d, Bereich III).

## Patentansprüche

1. Leistungsstufe
- mit einem Arbeitsstromkreis, in dem eine Last (L) über die Source-Drain-Strecke eines Feldeffekt-Transistors (FET) an eine Gleichspannungsquelle (Q) angeschlossen ist,
- mit einem Steuerstromkreis, in dem in Serienschaltung die Gate-Source-Strecke des Feldeffekt-Transistors (FET), die Last (L), die Gleichspannungsquelle (Q) und ein Kondensator (C) so angeordnet sind, daß die Summe der Spannungen der Gleichspannungsquelle (Q) und an dem Kondensator (C) im Sinne einer Durchsteuerung des Feldeffekt-Transistors (FET) an dessen Gate-Source-Strecke schaltbar ist,
- mit einem Ladestromkreis, der in Serienschaltung die Gleichspannungsquelle (Q), den Kondensator (C) und eine Diode (D2) enthält, und
- mit einem Schalter (T1) parallel zu Gate-Source-Strecke und Last (L),
**dadurch gekennzeichnet,**
- daß der Ladestromkreis auch den Schalter (T1) und eine zweite Diode (D1) enthält, wobei der Kondensator (C) zwischen den beiden Dioden (D1; D2) angeordnet ist, und
- daß jedem der beiden Serienzweige (C-D1; C-D2), bestehend aus dem Kondensator (C) und einer benachbarten Diode (D1; D2) ein Widerstand (R2; R1) parallel geschaltet ist.

## Claims

1. Power output stage
- having an operating circuit in which a load (L) is connected via the source-drain junction of a field-affect transistor (FET) to a DC voltage source (Q),
- having a control circuit in which the gate-source junction of the field-effect transistor (FET), the load (L), the DC voltage source (Q) and a capacitor (C) are arranged in a series circuit such that the sum of the voltages of the DC voltage source (Q) and on the capacitor (C) can be connected to the gate-source junction of the field-effect transistor (FET), in the sense of switching on said field-effect transistor (FET),
- having a charging circuit which contains the DC voltage source (Q), the capacitor (C) and a diode (D2) in a series circuit, and
- having a switch (T1) in parallel with the gate-source junction and the load (L),
characterised in that,
- the charging circuit also contains the switch (T1) and a second diode (D1), the capacitor (C) being arranged between the two diodes (D1; D2), and
- a resistor (R2; R1) is connected in parallel with each of the two series branches (C-D1; C-D2) which comprise the capacitor (C) and an adjacent diode (D1; D2).

## Revendications

1. Étage de puissance comportant
- un circuit de travail, dans lequel une charge (L) est raccordée par l'intermédiaire de la voie source-drain d'un transistor à effet de champ (FET) à une source de tension continue (Q),
- un circuit de commande, dans lequel la voie grille-source du transistor à effet de champ (FET), la charge (L), la source de tension continue (Q) et un condensateur (C) sont branchés selon un circuit série de telle sorte que la somme des tensions aux bornes de la source de tension continue (Q) et aux bornes du condensateur (C) peut être commutée, pour une mise à l'état passant du transistor à effet de champ (FET), à la voie grille-source de ce dernier,
- un circuit de charge qui contient, selon un montage en série, la source de tension continue (Q), le condensateur (C) et une diode (D2), et
- un interrupteur (T1) branché en parallèle avec la voie grille-source et la charge (L),
caractérisé par le fait
- que le circuit de charge contient également un interrupteur (T1) et une seconde diode (D1), le condensateur (C) étant disposé entre les deux diodes (D1; D2), et
- qu'une résistance (R2;R1) est branchée en parallèle avec chacun des deux montages série (CD-1; CD-2), qui sont constitués par le condensateur (C) et une diode voisine (D1;D2).
